# FASCICULE DE BREVET EUROPEEN

(11) **EP 1 589 565 B1**
(45) Date de publication et mention de la délivrance du brevet: **03.01.2007**
(21) Numéro de dépôt: 05290812.6
(22) Date de dépôt: 13.04.2005
(51) Int. Cl.: H01L 21/00, H01L 21/673

(54) **Dispositif pour le transport de substrats sous atmosphère controlée**
Vorrichtung zum Transport von Substraten unter kontrollierter Atmosphäre
Apparatus for transporting substrates under controlled environment

(30) Priorité: 21.04.2004 FR 0450751
(43) Date de publication de la demande: 26.10.2005
(73) Titulaire: ALCATEL, 75008 Paris (FR)
(72) Inventeur: Bernard, Roland, 74540 Viuz-la-Chiesaz (FR); Kambara, Hisanori, 74350 Villy-le-Pelloux (FR); Rival, Jean-Luc, 74370 Villaz (FR); Le Guet, Catherine, 73290 La Motte-Cervolex (FR)
(74) Mandataire: Lamoureux, Bernard

(56) Documents cités:
- EP-A- 0 617 573
- EP-A- 0 692 816
- EP-A- 0 791 952
- EP-A- 1 107 292
- WO-A-97/13947
- US-A- 5 255 783
- US-A- 5 549 205
- US-A1- 2002 124 906
- US-B1- 6 214 425
- PATENT ABSTRACTS OF JAPAN vol. 1997, no. 05, 30 mai 1997 (1997-05-30) -& JP 09 027542 A (HITACHI LTD; JAPAN STEEL WORKS LTD:THE), 28 janvier 1997 (1997-01-28)

## Description

La présente invention concerne la conservation et le déplacement des substrats tels que les plaquettes de semi-conducteurs ou les masques dans les salles blanches, entre les différentes étapes de travail au cours desquelles les substrats sont utilisés pour les procédés de fabrication de semi-conducteurs et de systèmes mécaniques microélectroniques (MEMS).

Dans la fabrication de semi-conducteurs et de systèmes mécaniques microélectroniques, des substrats tels que les plaquettes de silicium ou les masques sont transportés dans des enceintes de mini-environnement qui les protègent des pollutions qui sont encore présentes dans l'atmosphère des salles blanches.

Actuellement, les plaquettes de silicium de 200 millimètres de diamètre sont transportées dans des enceintes à ouverture par le bas que l'on désigne généralement par l'expression enceinte d'interface standardisée (SMIF).

Les plaquettes de silicium de 300 millimètres de diamètre sont transportées dans des enceintes à ouverture frontale que l'on désigne généralement par l'expression enceinte à ouverture frontale standardisée (FOUP).

On a également imaginé des enceintes de mini-environnement adaptées pour le transport d'une seule plaquette de substrat.

Les plaquettes de semi-conducteur ou autres plaquettes restent typiquement pendant plusieurs semaines dans l'unité de fabrication de semi-conducteurs, entre les diverses étapes des procédés. Au cours de cette durée, les plaquettes de semi-conducteur ou autres plaquettes doivent être protégées contre tout risque de pollution, et c'est la raison pour laquelle on prévoit de les isoler de l'atmosphère intérieure des salles blanches, en les transportant et en les conservant dans les enceintes de mini-environnement.

Une enceinte de mini-environnement doit être autonome pendant les étapes de déplacement entre les différents postes de travail. Durant cette période d'autonomie, l'enceinte de mini-environnement doit elle-même maintenir l'atmosphère contrôlée autour du substrat qu'elle contient. Cela nécessite une source d'énergie disponible dans l'enceinte de mini-environnement, et un système de pompage pour l'entretien de l'atmosphère contrôlée qui est à très faible pression, pression qui est de l'ordre de celles qui règnent dans les chambres de transfert et de chargement vers les chambres de procédés.

Dans les standards récents en vigueur dans la fabrication des semi-conducteurs, la plaquette de semi-conducteur à protéger est généralement conservée avec la face active de la plaquette dirigée vers le haut, mais les masques peuvent être conservés avec une face active soit dirigée vers le haut, soit dirigée vers le bas. Par exemple, les masques pour gravure EUV (Extrême Ultra Violet) ont leur face active dirigée vers le bas. Il faut alors disposer d'une enceinte de mini-environnement qui puisse être compatible avec un positionnement d'un substrat dont la face active est dirigée soit vers le haut, soit vers le bas, qui soit compatible avec des stations de conditionnement sur lesquelles peuvent être accouplées les enceintes de mini-environnement pour les stockages de longue durée, et qui soit compatible avec les structures d'entrée-sortie vers les chambres de transfert et de chargement et vers les chambres de procédés.

EP1107292 décrit un dispositif pour le transport, sous atmosphère contrôlée, de substrats dont la face active est dirigée vers le haut.

Ainsi, un premier problème proposé par l'invention est de concevoir une structure d'enceinte de mini-environnement qui assure une protection efficace du substrat qu'elle contient, tout en étant aisément compatible tant avec des substrats dont la face active est dirigée vers le haut qu'avec des substrats dont la face active est dirigée vers le bas. La compatibilité doit être assurée de manière simple et à faible coût.

Un second problème proposé par l'invention est de concevoir une structure d'enceinte de mini-environnement qui présente à la fois un encombrement suffisamment réduit et une autonomie satisfaisante pour le maintien de l'atmosphère contrôlée pendant les étapes de transport de substrat et éventuellement pendant des étapes de stockage de substrat de durée appropriée.

L'invention propose ainsi un dispositif pour le transport de substrats sous atmosphère contrôlée, comprenant une enceinte de mini-environnement avec une cavité intérieure.

Selon un premier aspect de l'invention, pour résoudre le problème des dispositions inversées possibles des substrats, avec leur face active orientée vers le haut ou avec leur face active orientée vers le bas, et pour faciliter la fabrication, l'invention propose une enceinte de mini-environnement comprenant :
- une coque périphérique, ouverte sur une première face principale et sur une seconde face principale opposées l'une à l'autre, et comportant une ouverture latérale obturable pour l'introduction et l'extraction des substrats,
- une première paroi principale, conformée pour être rapportée et fixée sur l'une ou l'autre des première face principale ou seconde face principale selon l'orientation de la face active du substrat, et pour l'obturer de façon étanche,
- une seconde paroi principale, conformée pour être rapportée et fixée selon l'orientation de la face active du substrat, sur l'une ou l'autre des première face principale ou seconde face principale et pour l'obturer de façon étanche, la première paroi principale et la deuxième paroi principale étant disposées dans un plan parallèle au plan contenant les substrats.
- des moyens de pompage embarqués dont l'aspiration est connectée à la cavité intérieure de l'enceinte de mini-environnement pour entretenir un vide contrôlé dans la cavité intérieure de l'enceinte de mini-environnement, selon la revendication 1.

On peut ainsi donner aux parois principales des fonctions différentes et interchangeables, de façon modulaire. Cela facilite aussi la fabrication de l'enceinte de mini-environnement.

Pour résoudre le problème de l'autonomie et des faibles dimensions des enceintes de mini-environnement, il convient d'utiliser un système de pompage embarqué sur l'enceinte de mini-environnement, avec également une source d'énergie embarquée. L'enceinte de mini-environnement étant étanche, la capacité de pompage peut être faible, juste suffisante pour maintenir le vide approprié pendant la durée d'autonomie désirée. On peut ainsi envisager d'utiliser une micropompe, par exemple une micropompe constituée d'une pluralité de cellules élémentaires à transpiration thermique, qui fonctionne de façon satisfaisante lorsque la pression des gaz est basse. Mais la difficulté est alors qu'une telle micropompe n'est pas capable de refouler les gaz pompés vers l'atmosphère, et qu'elle nécessite alors une pompe primaire connectée en série au refoulement de la micropompe, et refoulant elle-même à l'atmosphère. Cela nécessite alors une source d'énergie de capacité suffisante pour alimenter non seulement la micropompe mais également la pompe primaire, et cela augmente l'encombrement et le poids de l'enceinte de mini-environnement sur laquelle doivent être embarquées la micropompe, la pompe primaire et la source d'énergie. Il n'est alors pas possible d'envisager un ensemble de volume et de poids suffisamment réduits.

L'invention propose pour cela, selon un mode de réalisation avantageux :
- une micropompe, dont l'aspiration est connectée à la cavité intérieure de l'enceinte de mini-environnement,
- une chambre de réserve de vide primaire, isolée de la cavité intérieure de l'enceinte de mini-environnement et isolée de l'atmosphère extérieure, connectée au refoulement de la micropompe, et ayant un orifice de pompage primaire obturable permettant sa connexion à un dispositif de pompage externe,
- une réserve d'énergie pour alimenter la micropompe en énergie assurant son fonctionnement.

Pour établir le vide approprié dans l'enceinte de mini-environnement, on connecte l'orifice de pompage primaire à un dispositif de pompage externe et on fait fonctionner simultanément la micropompe et le dispositif de pompage externe. Ensuite, on déconnecte l'orifice de pompage primaire et on l'obture pour conserver le vide ainsi réalisé. L'enceinte de mini-environnement est alors autonome. La micropompe entretient le vide contrôlé dans la cavité intérieure, en refoulant les gaz dans la chambre de réserve, dont la pression va progressivement augmenter.

Il est naturellement possible de prévoir une chambre de réserve ayant un volume suffisamment grand, pour que sa pression interne augmente plus lentement. Toutefois, pour éviter d'augmenter inconsidérément le volume total de l'ensemble, la chambre de réserve peut avantageusement présenter un volume seulement suffisant pour que, pendant la durée satisfaisante d'autonomie du dispositif de transport, la pression interne dans la chambre de réserve, qui augmente progressivement par l'effet des gaz pompés par la micropompe hors de la cavité intérieure de l'enceinte de mini-environnement et refoulés dans la chambre de réserve, n'atteigne pas le seuil maximum de pression au-delà duquel la micropompe n'est plus capable d'assurer le refoulement des gaz pompés.

Comme déjà envisagé, la micropompe peut avantageusement comprendre une pluralité de cellules élémentaires de pompage à transpiration thermique. De telles cellules de pompage à transpiration thermique utilisent l'effet de transpiration thermique mis en évidence par Knudsen dans les années 1900, effet selon lequel, lorsque deux volumes successifs sont reliés par un canal de dimensions transversales très faibles, dont le rayon est inférieur au libre parcours moyen des molécules gazeuses présentes, et lorsque les extrémités du canal sont à des températures différentes, une différence de pression s'établit entre les deux volumes successifs. Dans le canal de petite dimension, les molécules se déplacent selon un régime moléculaire, et il en résulte que les pressions diffèrent aux deux extrémités du canal par suite de la différence des températures. En régime moléculaire, lorsque l'équilibre thermique est atteint, les pressions aux deux extrémités du canal sont telles que leur rapport est égal à la racine carrée du rapport des températures correspondantes. Lorsque les molécules atteignent le volume adjacent à l'extrémité du canal, leur déplacement suit alors le régime d'un milieu visqueux, et elles ne peuvent pas retourner dans le canal. Cela produit un effet de pompage.

Le taux de compression d'une cellule élémentaire est faible, mais il est possible de multiplier le nombre de cellules connectées aérauliquement en série et/ou en parallèle, afin d'atteindre le taux de compression approprié et la capacité de pompage appropriée.

Une telle enceinte de mini-environnement est ainsi adaptée pour présenter une autonomie satisfaisante, grâce à la faible consommation de la micropompe, et grâce au fait qu'il n'est pas nécessaire d'utiliser une pompe primaire pour refouler à l'atmosphère pendant la durée d'autonomie envisagée.

Le dispositif peut en outre avantageusement comprendre une station de conditionnement :
- adaptée pour recevoir l'enceinte de mini-environnement et pour se connecter à l'orifice de pompage primaire,
- comportant une pompe primaire et des moyens de commande pour aspirer les gaz hors de la chambre de réserve afin d'établir un vide approprié dans la chambre de réserve et dans la cavité intérieure de l'enceinte de mini-environnement.

L'intérêt est que la station de conditionnement est capable d'établir l'atmosphère à basse pression dans l'enceinte de mini-environnement, au cours d'une étape préalable de conditionnement, et ensuite l'enceinte de mini-environnement isole son atmosphère intérieure par rapport à l'atmosphère ambiante de la salle blanche, et la micropompe alimentée par la source d'énergie embarquée suffit à maintenir l'atmosphère intérieure dans les conditions appropriées, pendant la durée d'autonomie, l'enceinte de mini-environnement étant alors déconnectée de la station de conditionnement.

De préférence, sur la station de conditionnement, la pompe primaire coopère avec des moyens de connexion pour le raccordement de son aspiration à la chambre de réserve de l'enceinte de mini-environnement. Ainsi, le conditionnement de l'atmosphère intérieure de l'enceinte de mini-environnement s'effectue par pompage des gaz tout d'abord à travers la micropompe, puis à travers la pompe primaire, qui sont connectées aérauliquement en série.

Selon un mode de réalisation avantageux :
- la micropompe est d'un type utilisant l'énergie électrique,
- la réserve d'énergie de l'enceinte de mini-environnement comprend des moyens accumulateurs d'énergie électrique,
- la station de conditionnement comprend des moyens de source d'énergie électrique et des moyens de connexion électrique pour recharger la réserve d'énergie de l'enceinte de mini-environnement.

Les dispositions mentionnées ci-dessus sont adaptées pour résoudre le problème de l'autonomie.

En pratique, pour loger la micropompe et la réserve d'énergie, on peut prévoir que la seconde paroi principale comprend la micropompe dont l'aspiration est connectée à la cavité intérieure de l'enceinte de mini-environnement, la réserve d'énergie pour alimenter la micropompe, et la chambre de réserve connectée au refoulement de la micropompe et ayant l'orifice de pompage primaire obturable.

Selon un mode de réalisation particulier, la première paroi principale comprend une plaque de décontamination par thermophorèse, et des moyens pour refroidir ladite plaque de décontamination.

Pour être efficace, il est nécessaire que cette plaque soit disposée parallèlement en vis-à-vis et le plus proche possible de la face active du substrat.

Selon un mode de réalisation avantageux, les moyens pour refroidir la plaque de décontamination par thermophorèse peuvent comprendre une ou plusieurs sources froides d'éléments Peltier.

Dans le cas d'utilisation d'une plaque de décontamination par thermophorèse, on peut aussi prévoir que la plaque de décontamination par thermophorèse soit munie de moyens de piège à particules. Ce piège peut capter les particules incidentes qui arrivent sur ou à proximité immédiate de la plaque de décontamination par thermophorèse, procurant ainsi un effet de décontamination amélioré.

On peut avantageusement prévoir, dans la chambre de réserve, un élément adsorbant qui adsorbe les molécules gazeuses et favorise ainsi le maintien d'une pression suffisamment basse dans la chambre de réserve.

En complément ou en alternative, on peut prévoir un élément adsorbant placé au contact de l'atmosphère de la cavité intérieure de l'enceinte de mini-environnement. L'élément adsorbant permet alors d'adsorber les molécules gazeuses, en participant ainsi au maintien du vide dans la cavité intérieure et à la décontamination moléculaire, en complément de la micropompe, ou à la place de la micropompe.

On comprendra que les moyens pour assurer l'autonomie de l'enceinte de mini-environnement, et notamment la chambre de réserve, la réserve d'énergie et la micropompe, constituent en eux-mêmes une invention qui peut être utilisée indépendamment des moyens permettant l'utilisation de la même structure d'enceinte de mini-environnement pour contenir des substrats dont la face active est orientée vers le haut ou dont la face active est orientée vers le bas.

D'autres objets, caractéristiques et avantages de la présente invention ressortiront de la description suivante de modes de réalisation particuliers, faite en relation avec les figures jointes, parmi lesquelles :
- la figure 1 est une vue schématique de côté en coupe transversale d'une enceinte de mini-environnement selon un premier mode de réalisation de l'invention, adaptée au transport ou au stockage d'un substrat dont la face active est orientée vers le haut ;
- la figure 2 illustre la structure modifiée de la figure 1 pour le transport ou l'entreposage d'un substrat dont la face active est orientée vers le bas ;
- la figure 3 illustre une variante de l'enceinte de mini-environnement de la figure 1 ;
- la figure 4 illustre le détail d'un dispositif de serrage électrostatique pour le maintien d'une plaquette dans le dispositif de transport selon l'invention ; et
- la figure 5 illustre l'enceinte de mini-environnement selon le mode de réalisation de la figure 1, associée à une station de conditionnement.

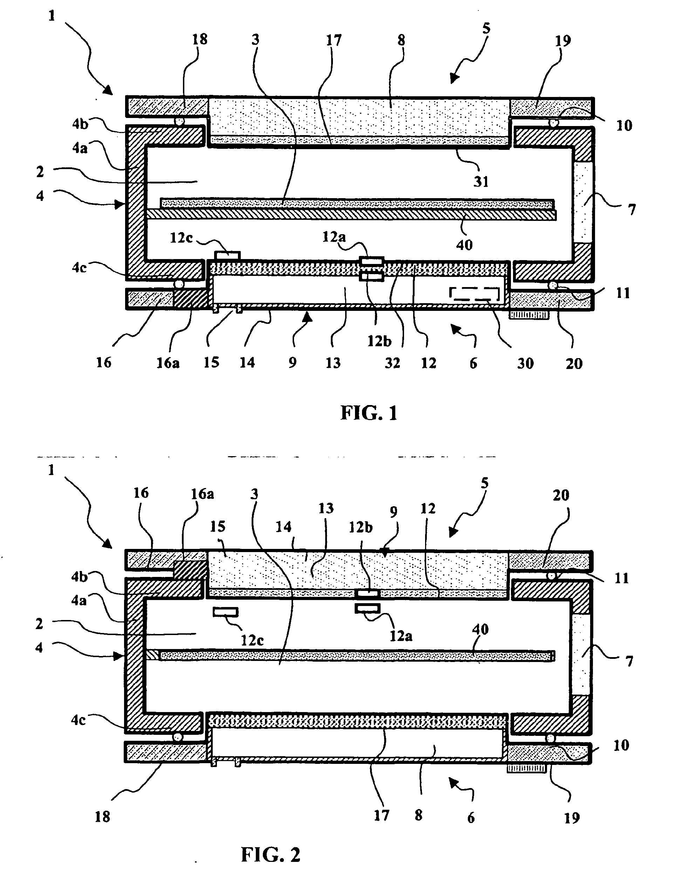

Dans le mode de réalisation illustré sur la figure 1, une enceinte de mini-environnement 1 selon l'invention comprend une cavité intérieure 2 conformée pour recevoir et contenir un substrat 3, tel qu'une plaquette de semi-conducteur, ou un masque, utilisés dans l'industrie des semi-conducteurs.

La dimension de la cavité intérieure 2 est choisie en fonction de la taille du substrat 3 à contenir, et on prévoit, de préférence, que les dimensions de la cavité intérieure 2 sont seulement peu supérieures aux dimensions du substrat 3, de façon à ne laisser autour du substrat 3 qu'une atmosphère à volume relativement réduit, plus facile à maintenir dans un état satisfaisant pendant une longue période d'autonomie.

La cavité intérieure 2 présente avantageusement une forme ayant une portion cylindrique adaptée pour suivre le contour d'une plaquette de semi-conducteur 3 en forme de disque. Cette forme permet toutefois de contenir les masques à contour carré.

La cavité intérieure 2 est entourée de parois étanches, comprenant une paroi périphérique 4a, une première paroi principale 8, et une seconde paroi principale 9. Les première et seconde parois principales sont disposées dans un plan parallèle au plan contenant les substrats.

Dans la réalisation illustrée sur la figure 1, la première paroi principale 8 forme la paroi supérieure, tandis que la seconde paroi principale 9 forme la paroi inférieure de l'enceinte de mini-environnement 1.

Dans ce même mode de réalisation, l'enceinte de mini-environnement 1 comprend des moyens de pompage embarqués pour entretenir un vide contrôlé dans la cavité intérieure 2 de l'enceinte de mini-environnement 1.

La figure 1 illustre le détail de constitution de l'enceinte de mini-environnement 1, et notamment les moyens qui permettent d'utiliser la même structure d'enceinte de mini-environnement pour contenir et transporter des substrats 3 qui ont soit leur face active tournée vers le haut, soit leur face active tournée vers le bas.

La coque périphérique 4 forme, par exemple, la paroi périphérique 4a et des retours 4b et 4c qui ferment une partie périphérique réduite des faces principales supérieure 5 et inférieure 6. Ainsi, la coque périphérique 4 est largement ouverte sur la première face principale 5 et sur la seconde face principale 6.

La première paroi principale 8 est conformée pour être rapportée et fixée sur l'une ou l'autre des première face principale 5 ou seconde face principale 6 selon l'orientation de la face active du substrat, et pour l'obturer de façon étanche.

De même, la seconde paroi principale 9 est conformée pour être rapportée et fixée sur l'une ou l'autre des première face principale 5 ou seconde face principale 6 selon l'orientation de la face active du substrat, et pour l'obturer de façon étanche.

Sur la figure 1, la première paroi principale 8 est rapportée sur la première face principale 5, tandis que la seconde paroi principale 9 est rapportée sur la seconde face principale 6.

Un joint d'étanchéité 10 est prévu pour assurer l'étanchéité entre la première paroi principale 8 et la coque périphérique 4, tandis qu'un joint d'étanchéité 11 est prévu pour assurer l'étanchéité entre la seconde paroi principale 9 et la coque périphérique 4, autour des ouvertures des faces principales 5 et 6.

Selon un mode de réalisation de l'invention, les moyens de pompage embarqués comprennent une micropompe 12, dont l'aspiration 12a est connectée à la cavité intérieure 2 de l'enceinte de mini-environnement 1. Une réserve d'énergie 16 permet d'alimenter la micropompe 12 en énergie assurant son fonctionnement. Une chambre de réserve 13, isolée de la cavité intérieure 2 de l'enceinte de mini-environnement 1, et isolée de l'atmosphère extérieure, est connectée au refoulement 12b de la micropompe 12. La chambre de réserve 13 comprend un orifice de pompage primaire 15 obturable, qui permet sa connexion à un dispositif de pompage externe comme cela sera expliqué plus loin.

Un contrôle de l'atmosphère présente dans la cavité intérieure 2 peut être assuré en prévoyant des moyens de capteurs 12c au contact de l'atmosphère intérieure et associés à des moyens de contrôle et de commande 16a. Les moyens de contrôle et de commande 16a peuvent, si désiré, moduler l'alimentation de la micropompe 12 en énergie électrique provenant de la réserve d'énergie 16 en fonction des signaux émis par les moyens de capteurs 12c.

On peut en outre prévoir une unité 20 de commande de traçabilité de l'enceinte de mini-environnement, avec des moyens pour le contrôle et la mémorisation des événements intervenus dans l'enceinte de mini-environnement 1.

La micropompe 12 peut avantageusement être une micropompe à transpiration thermique, constituée d'une pluralité de cellules de pompage élémentaires dont certaines sont connectées en série, plusieurs sous-ensembles série pouvant être connectés en parallèle, afin d'obtenir les propriétés désirées de débit et de taux de compression pour l'application envisagée.

Les cellules élémentaires de pompage par transpiration thermique comportent une source chaude pouvant être une résistance électrique, qui est alors alimentée en énergie électrique pour produire l'effet de compression. La réserve d'énergie 16 de l'enceinte de mini-environnement 1 comprend alors des moyens accumulateurs d'énergie électrique, par exemple un accumulateur électrique rechargeable.

Les cellules élémentaires de pompage par transpiration thermique peuvent être implémentées directement dans la paroi intermédiaire séparant la cavité intérieure 2 et la chambre de réserve 13. Il n'est pas nécessaire de connecter toutes les cellules à un orifice commun d'aspiration 12a et à un orifice commun de refoulement 12b. En pratique, on pourra concevoir des groupes distincts de cellules élémentaires de pompage par transpiration thermique connectés à des orifices respectifs d'aspiration et à des orifices respectifs de refoulement répartis selon la surface de la paroi intermédiaire.

La chambre de réserve 13 a pour but de recueillir les molécules gazeuses extraites par la micropompe 12 hors de la cavité intérieure 2 pendant les périodes d'autonomie de l'enceinte de mini-environnement 1. Ces molécules gazeuses peuvent provenir par exemple d'un dégazage des parois de l'enceinte de mini-environnement 1, ou d'un dégazage du substrat 3 introduit dans l'enceinte de mini-environnement 1, ou de fuites dans les parois de l'enceinte de mini-environnement 1. Au cours de la période d'autonomie de l'enceinte de mini-environnement 1, les molécules gazeuses transférées dans la chambre de réserve 13 augmentent progressivement la pression régnant à l'intérieur de la chambre de réserve 13, qui devient supérieure à la pression désirée dans la cavité intérieure 2 pour le maintien du substrat 3 dans une atmosphère appropriée. Il faut donner à la chambre de réserve 13 un volume suffisant, tel que la pression des molécules gazeuses dans la chambre de réserve 13 en fin de période d'autonomie reste encore inférieure à un seuil de pression aval maximum admissible par la micropompe 12, seuil au-delà duquel la micropompe 12 n'est plus capable d'assurer le transfert des molécules gazeuses depuis la cavité intérieure 2 jusqu'à la chambre de réserve 13.

En pratique, la micropompe 12 peut maintenir dans la cavité intérieure 2 un vide d'environ 10 mTorr, tandis que le refoulement de la micropompe 12 peut atteindre un niveau de 1 Torr.

Dans la réalisation illustrée sur la figure 1, la seconde paroi principale 9 contient la micropompe 12. La micropompe 12 est logée dans la paroi intermédiaire qui sépare la chambre de réserve 13 de la cavité intérieure 2 de l'enceinte de mini-environnement 1. Une paroi externe 14 isole la chambre de réserve 13 par rapport à l'atmosphère extérieure. Cette paroi externe 14 comprend l'orifice de pompage primaire 15 obturable qui permet l'accouplement sur une station de conditionnement.

On peut en outre prévoir, dans la seconde paroi principale 9, la réserve d'énergie 16 telle qu'un accumulateur électrique, qui permet d'alimenter en énergie électrique la micropompe 12, ainsi que les moyens de capteurs 12c et les moyens de contrôle et de commande 16a.

La première paroi principale 8 de ce mode de réalisation de la figure 1 comprend une plaque de décontamination 17 par thermophorèse, constituant le plafond de la cavité intérieure 2 de l'enceinte de mini-environnement 1 et disposée parallèlement et en vis-à-vis de la face active du substrat. La plaque de décontamination 17 par thermophorèse est une plaque maintenue à une température basse par un générateur de froid 18 alimenté par une réserve d'énergie 19. Ainsi, le générateur de froid 18 et la réserve d'énergie 19 sont contenus dans la première paroi principale 8, qui porte la plaque de décontamination 17 par thermophorèse.

De préférence, la plaque de décontamination 17 par thermophorèse est montée de façon amovible sur l'enceinte de mini-environnement 1, de façon à être retirée temporairement de l'enceinte de mini-environnement 1 ou changée contre une autre plaque de décontamination. Le retrait peut se faire soit en retirant la première paroi 8 entière, soit en retirant la plaque de décontamination 17 seule par l'ouverture latérale 7 obturable. Cela permet la régénération de la plaque de décontamination 17 à l'écart de l'enceinte de mini-environnement 1, par balayage d'azote et/ou par chauffage.

La structure d'ouverture latérale obturable 7 est conformée, de façon connue, pour coopérer avec des moyens externes d'ouverture et de fermeture automatiques, et avec des moyens de manipulation du substrat 3 pour son introduction ou son extraction. Il en résulte que, habituellement, l'ouverture latérale obturable 7 présente une structure non symétrique qui ne permettrait pas le retournement de l'enceinte de mini-environnement 1 pour une utilisation indifférenciée avec les parois principales 8 et 9 orientées vers le haut ou vers le bas, permettant le conditionnement et le transport d'un substrat 3 dont la face active est elle-même orientée vers le haut ou vers le bas.

Pour cela, la structure générale de la figure 1, en trois parties principales, à savoir une coque périphérique 4, une première paroi principale 8 rapportée et une seconde paroi principale 9 rapportée, réalise une symétrie par rapport à un plan horizontal médian, permettant de positionner la première paroi principale 8 soit sur la face supérieure 5 soit sur la face inférieure 6 de la coque périphérique 4. Cela permet ainsi de conserver la structure d'entrée-sortie constituée par l'ouverture latérale obturable 7, sans modifier son orientation, en plaçant les parois principales 8 et 9 soit en partie supérieure, soit en partie inférieure de la coque périphérique 4.

Ainsi, la figure 1 illustre la position de l'enceinte de mini-environnement 1 avec la première paroi principale 8 rapportée sur la première face principale 5, avec la seconde paroi principale 9 rapportée sur la seconde face principale 6.

A l'inverse, la figure 2 illustre la même structure de coque périphérique 4 qui reçoit la première paroi principale 8 sur sa seconde face principale 6 et la seconde paroi principale 9 sur sa première face principale 5.

Grâce à l'inversion possible des première et seconde parois principales 8 et 9 sur la même coque périphérique 4, on peut ainsi disposer la plaque de décontamination 17 soit au-dessus du substrat 3, lorsque le substrat 3 a sa face active orientée vers le haut, soit au-dessous du substrat 3, lorsque ce substrat 3 a sa face active orientée vers le bas.

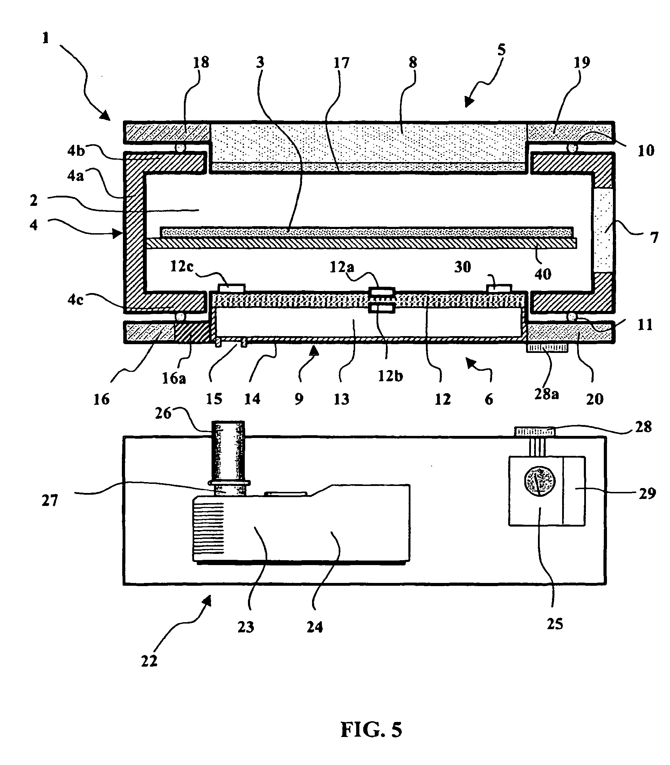

On se référera maintenant à la figure 5, qui illustre un mode de réalisation du dispositif complet selon l'invention, comprenant l'enceinte de mini-environnement 1 telle que précédemment décrite, et une station de conditionnement 22.

La station de conditionnement 22 est adaptée pour recevoir l'enceinte de mini-environnement 1 et pour se connecter à l'orifice de pompage primaire 15. Elle comprend pour cela un moyen de connexion 26 adapté pour se connecter de manière étanche à l'orifice de pompage primaire 15. Le moyen de connexion 26 est raccordé à l'aspiration d'une pompe primaire 23 associée à des moyens de commande 24 pour aspirer les gaz hors de la chambre de réserve 13 lorsque l'enceinte de mini-environnement 1 est accouplée à la station de conditionnement 22. La pompe primaire 23 se trouve alors connectée aérauliquement en série avec la micropompe 12, afin d'établir dans la cavité intérieure 2 de l'enceinte de mini-environnement 1 une pression gazeuse appropriée, par exemple de l'ordre de 10 mTorr. La pompe primaire 23 doit être capable d'atteindre sensiblement cette pression de fonctionnement de 10 mTorr.

On comprend que la présence de la chambre de réserve 13 permet un fonctionnement correct d'une micropompe 12, pendant toute la période d'autonomie de l'enceinte de mini-environnement 1, sans nécessiter la présence d'une pompe primaire embarquée sur l'enceinte de mini-environnement 1, et sans nécessiter de moyens pour alimenter cette pompe primaire embarquée.

En considérant encore la figure 5, la pompe primaire 23 coopère avec des moyens de connexion tels qu'une canalisation 26 pour la connexion et le raccordement de son aspiration 27 à la chambre de réserve 13 de l'enceinte de mini-environnement 1. Pour cela, la canalisation 26 est conformée pour s'accoupler à l'orifice de pompage primaire 15 obturable lors de l'accouplement de l'enceinte de mini-environnement 1 sur la station de conditionnement 22. Au désaccouplement de l'enceinte de mini-environnement 1, l'orifice de pompage primaire 15 obturable est à nouveau obturé pour conserver le vide dans la chambre de réserve 13 et dans la cavité intérieure 2.

La pompe primaire 23 est associée à des moyens de commande 24, pour piloter l'aspiration des gaz de l'enceinte de mini-environnement 1 afin d'établir un vide approprié lors de l'accouplement de l'enceinte de mini-environnement 1. La station de conditionnement 22 comprend en outre des moyens 25 pour recharger la réserve d'énergie 16 de l'enceinte de mini-environnement 1. Pour cela, on prévoit des moyens de connexion électrique 28, prévus sur la station de conditionnement 22, et correspondant à des moyens de connexion électrique 28a prévus sur l'enceinte de mini-environnement 1. On prévoit en outre, dans la station de conditionnement 22, des moyens de contrôle 29 pour contrôler le vide réalisé dans l'enceinte de mini-environnement 1, les moyens de contrôle 29 étant associés pour cela à des capteurs d'état tels que les moyens de capteurs 12c placés dans l'enceinte de mini-environnement 1.

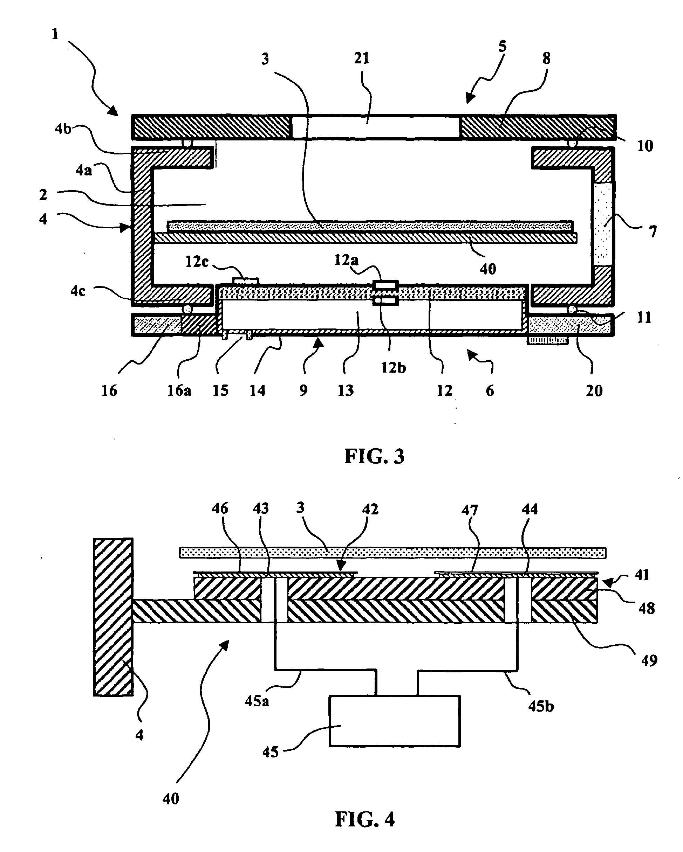

La figure 3 illustre un second mode de réalisation d'une enceinte de mini-environnement 1 selon l'invention, comportant la même structure de seconde paroi principale 9, mais une structure différente de première paroi principale 8. Dans ce cas, la première paroi principale 8 est dépourvue de plaque de décontamination par thermophorèse, mais comprend une fenêtre transparente 21 qui permet à l'utilisateur de voir le contenu de l'enceinte de mini-environnement 1.

Dans les modes de réalisation comportant une chambre de réserve 13, il peut être utile de prolonger la durée d'effet de la chambre de réserve 13 en prévoyant que la chambre de réserve 13 contient un élément adsorbant 30 (figure 1) susceptible d'adsorber les molécules gazeuses et de favoriser ainsi le maintien d'une pression basse dans la chambre de réserve 13.

Un exemple de matériau possible pour réaliser l'élément adsorbant 30 est constitué par des zéolithes. Les zéolithes sont des silico-aluminate alcalins cristallisés en structure stable, présentant une microporosité régulière et importante dans laquelle les cations sont aussi mobiles que dans un liquide. Il en résulte une capacité d'échange, d'adsorption et de catalyse. Les zéolithes constituent une structure solide définissant de grandes cavités internes dans lesquelles les molécules peuvent être adsorbées. Ces cavités sont interconnectées par des ouvertures de pores à travers lesquels les molécules peuvent passer. Grâce à la nature cristalline, les pores et les cavités ont des tailles régulières et très voisines, et, en fonction de la taille des ouvertures, la structure peut adsorber certaines molécules correspondant à la taille des ouvertures, alors que d'autres molécules plus grosses sont rejetées. On choisira donc les zéolithes appropriées en fonction de la taille des molécules gazeuses à adsorber.

En alternative, comme élément adsorbant 30, on peut utiliser tous autres matériaux qui constituent habituellement des pompes à sorbeur ou pompe getter.

En alternative ou en complément, comme illustré sur la figure 1, dans les modes de réalisation comportant une plaque de décontamination 17 par thermophorèse, on peut prévoir des moyens de piège à particules 31 pour capter les particules incidentes.

Ce piège à particules 31 est prévu selon la face active de la plaque de décontamination 17 par thermophorèse, ou face tournée vers le substrat 3.

En pratique, la plaque de décontamination 17 par thermophorèse peut être réalisée en un matériau qui présente en lui-même des propriétés de piège à particules par adhésion des particules incidentes. En alternative ou en complément, la plaque de décontamination 17 par thermophorèse peut avoir reçu, sur sa face active, un traitement de surface approprié lui conférant les propriétés de piège à particules.

Par exemple, la face active de la plaque de décontamination 17 par thermophorèse peut être la face externe d'une mince couche de surface en matériau approprié appliqué sur la plaque de décontamination 17 elle-même.

Dans un autre mode de réalisation de l'invention, on peut remplacer, dans la seconde paroi principale 9, la micropompe 12 et la chambre de réserve 13 par une pompe à sorbeur ou pompe getter. L'élément adsorbant 32 de la pompe à sorbeur ou pompe getter peut être prévu dans la seconde paroi principale 9, comme illustré sur la figure 1. L'élément adsorbant 32 peut de préférence être rendu amovible pour son interchangeabilité et/ou sa régénération à l'extérieur de l'enceinte de mini-environnement, après une période d'utilisation, étant donné que la régénération nécessite un échauffement relativement important de la matière adsorbante, échauffement qui pourrait dégrader l'enceinte de mini-environnement 1. On choisira un élément adsorbant qui a des propriétés sorbantes satisfaisantes jusqu'à des températures relativement basses, pour éviter les dépenses d'énergie embarquée.

L'élément adsorbant 32 présente en général des propriétés de désorption lorsqu'il est porté à une température élevée, et des propriétés d'adsorption lorsqu'il est à température plus basse. On peut donc généralement régénérer l'élément adsorbant 32 par un chauffage suffisant lorsqu'il est à l'extérieur de l'enceinte de mini-environnement 1. Et on peut avantageusement introduire l'élément adsorbant 32 encore relativement chaud dans l'enceinte de mini-environnement 1, c'est-à-dire à une température suffisamment élevée pour présenter des propriétés adsorbantes satisfaisantes, mais inférieure aux températures produisant une désorption : le refroidissement progressif de l'élément adsorbant 32 et des gaz présents dans la cavité intérieure 2 produit une baisse progressive de la pression gazeuse dans la cavité intérieure 2 et participe ainsi aux performances de pompage et au maintien d'un vide contrôlé dans la cavité 2 pendant le transport et/ou le stockage de substrats dans l'enceinte de mini-environnement 1.

Dans tous les modes de réalisation qui ont été décrits, il convient de tenir le substrat 3 dans la cavité intérieure 2 du dispositif. Le maintien du substrat 3 doit être suffisant pour éviter tous risques de dégradation du substrat 3 pendant le transport du dispositif, et il doit éviter tous risques de frottements susceptibles de générer des particules pouvant polluer la face principale du substrat 3 telle que la face d'une plaquette de semi-conducteur devant recevoir l'usinage pour réalisation des motifs constituant les composants à semi-conducteur. Il faut simultanément que le dispositif de maintien ne nécessite qu'une faible consommation d'énergie afin de ne pas réduire l'autonomie du dispositif de transport.

Il s'avère particulièrement intéressant d'utiliser à cet effet un dispositif de serrage électrostatique 40 pour tenir en position horizontale le substrat 3 dans la cavité intérieure 2.

Le détail de réalisation d'un dispositif de serrage électrostatique 40 est illustré sur la figure 4. Le dispositif comprend un plateau de serrage 41 définissant une surface de serrage 42 électriquement isolante et sur laquelle vient s'appliquer le substrat 3. Le plateau de serrage 41 comprend une pluralité d'électrodes 43 et 44, connectées électriquement par des conducteurs 45a et 45b à un circuit de commande de serrage 45. Les électrodes 43 et 44 sont recouvertes d'une couche isolante respective 46 et 47 de faible épaisseur, par exemple de l'ordre du micron, et sont portées par un plateau isolant 48 lui-même porté par un plateau métallique 49 solidaire de la coque périphérique 44.

Le circuit de commande de serrage 45 applique des tensions électriques de serrage aux électrodes 43 et 44, pour réaliser le serrage électrostatique du substrat 3 contre la surface de serrage 42. Les tensions électriques de serrage sont par exemple des tensions à ondes carrées, à une fréquence fondamentale de quelques dizaines de Hertz, et ayant une amplitude de l'ordre de 1 000 volts.

S'agissant d'un couplage électrostatique avec le substrat 3, la puissance électrique délivrée par le circuit de commande de serrage 45 est très faible, ce qui est donc compatible avec les besoins d'autonomie du dispositif de transport de substrat selon l'invention.

L'alimentation des électrodes 43 et 44 assure le serrage électrostatique du substrat 3, tandis que l'interruption de cette alimentation assure immédiatement la libération du substrat 3. Il n'y a donc aucun frottement pour assurer le serrage ou le desserrage du dispositif de serrage électrostatique, et donc aucune libération de particules polluantes.

La présente invention n'est pas limitée aux modes de réalisation qui ont été explicitement décrits, mais elle en inclut les diverses variantes et généralisations qui sont à la portée de l'homme du métier.

## Revendications

1. Dispositif pour le transport de substrats (3) sous atmosphère contrôlée, comprenant une enceinte de mini-environnement (1) comportant une cavité intérieure (2), une coque périphérique (4) ouverte sur une première face principale (5) et sur une seconde face principale (6) opposées l'une à l'autre, une première paroi principale (8) et une seconde paroi principale (9), **caractérisé en ce que**
- la coque périphérique comporte en outre une ouverture latérale obturable (7) pour l'introduction et l'extraction des substrats (3),
- la première paroi principale (8) est conformée pour être rapportée et fixée sur l'une ou l'autre des première face principale (5) ou seconde face principale (6) selon l'orientation de la face active du substrat, et pour l'obturer de façon étanche,
- la seconde paroi principale (9) est conformée pour être rapportée et fixée sur l'une ou l'autre des première face principale (5) ou seconde face principale (6) selon l'orientation de la face active du substrat, et pour l'obturer de façon étanche,
la première paroi principale et la deuxième paroi principale étant disposées dans un plan parallèle au plan contenant les substrats,
et **en ce que** l'enceinte de mini-environnement (1) comprend en outre des moyens de pompage (12) embarqués dont l'aspiration (12a) est connectée à la cavité intérieure (2) de l'enceinte de mini-environnement (1) pour entretenir un vide contrôlé dans la cavité intérieure (2) de l'enceinte de mini-environnement (1).

2. Dispositif selon la revendication 1, **caractérisé en ce qu'il** comprend :
- une micropompe (12), dont l'aspiration (12a) est connectée à la cavité intérieure (2) de l'enceinte de mini-environnement (1),
- une chambre de réserve (13) de vide primaire, isolée de la cavité intérieure (2) de l'enceinte de mini-environnement (1) et isolée de l'atmosphère extérieure, connectée au refoulement (12b) de la micropompe (12), et ayant un orifice de pompage primaire (15) obturable permettant sa connexion à un dispositif de pompage externe,
- une réserve d'énergie (16) pour alimenter la micropompe (12) en énergie assurant son fonctionnement.

3. Dispositif selon la revendication 2, dans lequel la chambre de réserve (13) présente un volume seulement suffisant pour que, pendant une durée satisfaisante d'autonomie du dispositif de transport, la pression interne dans la chambre de réserve (13), qui augmente progressivement par l'effet des gaz pompés par la micropompe (12) hors de la cavité intérieure (2) de l'enceinte de mini-environnement (1) et refoulés dans la chambre de réserve (13), n'atteigne pas le seuil maximum de pression au-delà duquel la micropompe (12) n'est plus capable d'assurer le refoulement des gaz pompés.

4. Dispositif selon l'une des revendications 2 ou 3, comprenant des moyens de capteurs (12c) au contact de l'atmosphère intérieure et associés à des moyens de contrôle et de commande (16a) pour moduler l'alimentation de la micropompe (12) en énergie.

5. Dispositif selon l'une quelconque des revendications 2 à 4, dans lequel la micropompe (12) comprend une pluralité de cellules élémentaires de pompage à transpiration thermique.

6. Dispositif selon l'une quelconque des revendications 2 à 5, dans lequel la seconde paroi principale (9) comprend la micropompe (12) dont l'aspiration est connectée à la cavité intérieure (2) de l'enceinte de mini-environnement (1), la réserve d'énergie (16) pour alimenter la micropompe (12), et la chambre de réserve (13) connectée au refoulement de la micropompe (12) et ayant l'orifice de pompage primaire (15) obturable.

7. Dispositif selon la revendication 6, dans lequel la première paroi principale (8) comprend une fenêtre transparente (21).

8. Dispositif selon la revendication 1, dans lequel la première paroi principale (8) comprend une plaque de décontamination (17) par thermophorèse, et des moyens (18) pour refroidir ladite plaque de décontamination (17).

9. Dispositif selon la revendication 8, dans lequel les moyens (18) pour refroidir ladite plaque de décontamination (17) par thermophorèse comprennent une ou plusieurs sources froides d'éléments Peltier.

10. Dispositif selon l'une des revendications 8 ou 9, dans lequel la plaque de décontamination (17) par thermophorèse comprend des moyens de piège à particules (31) pour capter les particules incidentes.

11. Dispositif selon l'une quelconque des revendications 8 à 10, dans lequel la plaque de décontamination (17) par thermophorèse est montée de façon amovible sur l'enceinte de mini-environnement (1), de façon à permettre sa régénération à l'écart de l'enceinte de mini-environnement (1) par balayage d'azote et/ou par chauffage.

12. Dispositif selon l'une quelconque des revendications 2 à 11, comprenant une station de conditionnement (22),
- adaptée pour recevoir l'enceinte de mini-environnement (1) et pour se connecter à l'orifice de pompage primaire (15),
- comportant une pompe primaire (23) et des moyens de commande (24) pour aspirer les gaz hors de la chambre de réserve (13) afin d'établir un vide approprié dans la chambre de réserve (13) et dans la cavité intérieure (2) de l'enceinte de mini-environnement (1).

13. Dispositif selon la revendication 12, dans lequel la pompe primaire (23) coopère avec des moyens de connexion (26) pour le raccordement de son aspiration (27) à une chambre de réserve (13) de l'enceinte de mini-environnement (1).

14. Dispositif selon l'une des revendications 12 ou 13, dans lequel :
- la micropompe (12) est d'un type utilisant l'énergie électrique,
- la réserve d'énergie (16) de l'enceinte de mini-environnement (1) comprend des moyens accumulateurs d'énergie électrique,
- la station de conditionnement (22) comprend des moyens de source d'énergie électrique (25) et des moyens de connexion électrique (28) pour recharger la réserve d'énergie (16) de l'enceinte de mini-environnement (1).

15. Dispositif selon l'une quelconque des revendications 2 à 14, dans lequel la chambre de réserve (13) contient un élément adsorbant (30) qui adsorbe les molécules gazeuses et favorise ainsi le maintien d'une pression suffisamment basse dans la chambre de réserve (13).

16. Dispositif selon l'une quelconque des revendications 1 à 13, **caractérisé en ce qu**'un élément adsorbant (32) est placé au contact de l'atmosphère de la cavité intérieure (2) de l'enceinte de mini-environnement (1), pour adsorber les molécules gazeuses en participant ainsi au maintien du vide dans la cavité intérieure (2) et à la décontamination moléculaire.

17. Dispositif selon la revendication 16, dans lequel l'élément adsorbant (32) est amovible, pour permettre son interchangeabilité et/ou sa régénération à l'extérieur de l'enceinte de mini-environnement (1).

18. Dispositif selon la revendication 17, dans lequel l'élément adsorbant (32) est d'un type présentant des propriétés de désorption à température élevée et des propriétés d'adsorption lorsqu'il est à température plus basse, et en ce qu'il est introduit encore relativement chaud dans l'enceinte de mini-environnement (1), de sorte que son refroidissement progressif participe aux performances de pompage et au maintien d'un vide contrôlé dans l'enceinte de mini-environnement (1).

19. Dispositif selon l'une quelconque des revendications 1 à 18, **caractérisé en ce qu**'il comprend un dispositif de serrage électrostatique (40) pour tenir en position le substrat (3) dans la cavité intérieure (2).

## Claims

1. Apparatus for transporting substrates (3) under a controlled atmosphere, the apparatus comprising a mini-environment enclosure (1) with an inside cavity (2), a peripheral shell (4) open to a first main face (5) and a second main face (6) that are opposite each other, a first main wall (8), and a second main wall (9), the apparatus being **characterized in that**:
· the peripheral shell further includes a closable side opening (7) for inserting and extracting substrates (3);
· the first main wall (8) is shaped to be fitted and secured to one or the other of the first and second main faces (5, 6) depending on the orientation of the active face of the substrate, and to close it in leaktight manner; and
· the second main wall (9) is shaped to be fitted and secured to one or the other of the first and second main faces (5, 6) depending on the orientation of the active face of the substrate, and to close it in leaktight manner, the first and second main walls being disposed in planes parallel to the plane containing the substrate;
and **in that** the mini-environment enclosure (1) further comprises on-board pumping means (12) having an inlet (12a) connected to the inside cavity (2) of the mini-environment enclosure (1) in order to maintain a controlled vacuum in the inside cavity (2) of the mini-environment enclosure (1).

2. Apparatus according to claim 1, **characterized in that** it comprises:
· a micropump (12) whose inlet (12a) is connected to the inside cavity (2) of the mini-environment enclosure (1);
· a primary vacuum reserve chamber (13) isolated from the inside cavity (2) of the mini-environment enclosure (1) and isolated from the outside atmosphere, connected to the outlet (12b) from the micropump (12), and having a closable primary pumping orifice (15) enabling it to be connected to an external pumping apparatus; and
· an energy supply (16) for powering the micropump (12) to enable it to operate.

3. Apparatus according to claim 2, in which the reserve chamber (13) presents a volume that is just sufficient to ensure that during a disconnection of satisfactory duration of the transport apparatus, the pressure in the reserve chamber (13), which increases progressively due to the gas pumped by the micropump (12) from the inside cavity (2) of the mini-environment enclosure (1) and delivered into the reserve chamber (13), does not reach the maximum pressure threshold above which the micropump (12) is no longer capable of delivering the gas it pumps.

4. Apparatus according to claim 2 or claim 3, including sensor means (12c) in contact with the inside atmosphere and associated with control means (16a) for modulating the supply of energy to the micropump (12).

5. Apparatus according to any one of claims 2 to 4, in which the micropump (12) comprises a plurality of individual thermal transpiration pumping cells.

6. Apparatus according to any one of claims 2 to 5, in which the second main wall (9) includes the micropump (12) whose inlet is connected to the inside cavity (2) of the mini-environment enclosure (1), the energy supply (16) for powering the micropump (12), and the reserve chamber (13) connected to the outlet from the micropump (12) and having the closable primary pumping orifice (15).

7. Apparatus according to claim 6, in which the first main wall (8) comprises a transparent window (21).

8. Apparatus according to claim 1, in which the first main wall (8) comprises a thermophoresis decontamination plate (17) and means (18) for cooling said decontamination plate (17).

9. Apparatus according to claim 8, in which the means (18) for cooling said thermophoresis decontamination plate (17) comprise one or more Peltier element cold sources.

10. Apparatus according to claim 8 or claim 9, in which the thermophoresis decontamination plate (17) includes particle-trap means (31) for capturing incident particles.

11. Apparatus according to any one of claims 8 to 10, in which the thermophoresis decontamination plate (17) is removably mounted on the mini-environment enclosure (1) so as to enable it to be regenerated away from the mini-environment enclosure (1) by being swept with nitrogen and/or by being heated.

12. Apparatus according to any one of claims 2 to 11, including a conditioning station (22):
· adapted to receive the mini-environment enclosure (1) and to connect with the primary pumping orifice (15); and
· including a primary pump (23) and control means (24) for pumping gas from the reserve chamber (13) in order to establish a suitable vacuum in the reserve chamber (13) and in the inside chamber (2) of the mini-environment enclosure (1).

13. Apparatus according to claim 12, in which the primary pump (23) cooperates with connection means (26) for coupling its inlet (27) to a reserve chamber (13) of the mini-environment enclosure (1).

14. Apparatus according to claim 12 or claim 13, in which:
· the micropump (12) is of a type that uses electrical energy;
· the energy supply (16) of the mini-environment enclosure (1) comprises means for storing electrical energy; and
· the conditioning station (22) includes electrical energy supply means (25) and electrical connection means (28) for recharging the energy supply (16) of the mini-environment enclosure (1).

15. Apparatus according to any one of claims 2 to 14, in which the reserve chamber (13) contains an adsorbent element (30) which adsorbs gas molecules and thus contributes to maintaining a sufficiently low pressure in the reserve chamber (13).

16. Apparatus according to any one of claims 1 to 13, **characterized in that** an adsorbent element (32) is placed in contact with the atmosphere of the inside cavity (2) of the mini-environment enclosure (1) to adsorb gas molecules, thereby contributing to maintaining a vacuum in the inside cavity (2) and to performing molecular decontamination.

17. Apparatus according to claim 16, in which the adsorbent element (32) is removable in order to enable it to be interchanged and/or regenerated outside the mini-environment enclosure (1).

18. Apparatus according to claim 17, in which the adsorbent element (32) is of a type presenting desorption properties at high temperature and adsorbent properties when at a lower temperature, and in which it is inserted while still relatively hot into the mini-environment enclosure (1) so that its progressive cooling contributes to pumping performance and maintaining a control vacuum in the mini-environment enclosure (1).

19. Apparatus according to any one of claims 1 to 18, **characterized in that** it includes an electrostatic clamp device (40) for holding the substrate (3) in position in the inside cavity (2).

## Patentansprüche

1. Vorrichtung zum Transport von Substraten (3) unter kontrollierter Atmosphäre, die einen Mini-Umgebungsbehälter (1) umfasst, der einen Innen-Hohlraum (2) umfasst, eine Kapsel (4), die auf einer ersten Hauptseite (5) und auf einer zweiten, gegenüberliegenden Hauptseite (6) offen ist, eine erste Hauptwand (8) und eine zweite Hauptwand (9), **dadurch gekennzeichnet, dass**
- die Kapsel außerdem eine seitliche verschließbare Öffnung (7) umfasst, die dem Einlegen und Entnehmen von Substraten (3) dient,
- die erste Hauptwand (8) so ausgelegt ist, dass sie je nach Ausrichtung der aktiven Seite des Substrats auf die erste Hauptseite (5) oder auf die zweite Hauptseite (6) aufgesetzt und befestigt werden kann und diese dicht verschließt,
- die zweite Hauptwand (9) so ausgelegt ist, dass sie je nach Ausrichtung der aktiven Seite des Substrats auf die erste Hauptseite (5) oder auf die zweite Hauptseite (6) aufgesetzt und befestigt werden kann und diese dicht verschließt,
wobei die erste Hauptwand und die zweite Hauptwand in einer Ebene angeordnet sind, die parallel zu der Ebene verläuft, in der sich die Substrate befinden,
und dadurch, dass der Mini-Umgebungsbehälter (1) außerdem integrierte Pumpvorrichtungen (12) umfasst, deren Saugfunktion (12a) an den Innen-Hohlraum (2) des Mini-Umgebungsbehälters (1) angeschlossen ist, um ein kontrolliertes Vakuum im Innen-Hohlraum (2) des Mini-Umgebungsbehälters (1) aufrecht zu erhalten.

2. Vorrichtung gemäß Anspruch 1, **dadurch gekennzeichnet, dass** sie Folgendes enthält:
- Eine Mikropumpe (12), deren Saugfunktion (12a) an den Innen-Hohlraum (2) des Mini-Umgebungsbehälters (1) angeschlossen ist,
- Eine Grobvakuum-Reservekammer (13), die vom Innen-Hohlraum (2) des Mini-Umgebungsbehälters (1) getrennt und von der Außenatmosphäre isoliert ist, die an den Förderausgang (12b) der Mikropumpe (12) angeschlossen ist und die einen verschließbaren Vorvakuum-Pumpdurchlass (15) aufweist, über den sie mit einer externen Pumpvorrichtung verbunden werden kann,
- Eine Energiereserve (16) zur Energieversorgung der Mikropumpe (12), die ihren Betrieb gewährleistet.

3. Vorrichtung gemäß Anspruch 2, **dadurch gekennzeichnet, dass** die Reservekammer (13) ein Volumen aufweist, das gerade ausreicht, damit der Innendruck in der Reservekammer (13), der aufgrund der Wirkung der von der Mikropumpe (12) aus dem Innen-Hohlraum (2) des Mini-Umgebungsbehälters (1) gepumpten und in die Reservekammer (13) geförderten Gase allmählich ansteigt, während einer ausreichenden Autonomiephase der Transportvorrichtung den oberen Druck-Grenzwert nicht übersteigt, über dem die Mikropumpe (12) nicht mehr in der Lage ist, die Förderung der gepumpten Gase zu gewährleisten.

4. Vorrichtung gemäß einem der Ansprüche 2 oder 3, die Sensorvorrichtungen (12c) umfasst, die Kontakt zur Innenatmosphäre haben und mit Kontroll- und Steuerungsvorrichtungen (16a) verbunden sind, die die Regelung der Stromversorgung für die Mikropumpe (12) gewährleisten.

5. Vorrichtung gemäß einem der Ansprüche 2 bis 4, in der die Mikropumpe (12) eine Vielzahl an Pump-Elementarzellen mit thermischer Transpiration umfasst.

6. Vorrichtung gemäß einem der Ansprüche 2 bis 5, in der die zweite Hauptwand (9) die Mikropumpe (12) umfasst, deren Saugfunktion an den Innen-Hohlraum (2) des Mini-Umgebungsbehälters (1) und die Energiereserve (16) zur Versorgung der Mikropumpe (12) angeschlossen ist und die Reservekammer (13) ist an den Förderausgang der Mikropumpe (12) angeschlossen und mit dem verschließbaren Vorvakuum-Pumpdurchlass (15) ausgestattet.

7. Vorrichtung gemäß Anspruch 6, in der die erste Hauptwand (8) ein lichtdurchlässiges Fenster (21) umfasst.

8. Vorrichtung gemäß Anspruch 1, in der die erste Hauptwand (8) eine Thermophorese-Entgiftungsplatte (17) und Mittel (18) zur Abkühlung der genannten Thermophorese-Entgiftungsplatte (17) umfasst.

9. Vorrichtung gemäß Anspruch 1, in der die Mittel (18) zur Abkühlung der genannten Thermophorese-Entgiftungsplatte (17) eine oder mehrere kalte Quelle/-n mit Peltier-Elementen umfassen.

10. Vorrichtung gemäß einem der Ansprüche 8 oder 9, in der die Thermophorese-Entgiftungsplatte (17) Vorrichtungen mit Partikel-Haftstellen (31) umfasst, die auftretende Partikel fangen.

11. Vorrichtung gemäß einem der Ansprüche 8 bis 10, in der die Thermophorese-Entgiftungsplatte (17) demontierbar im Mini-Umgebungsbehälter (1) installiert ist, so dass ihre Aufbereitung außerhalb des Mini-Umgebungsbehälters (1) durch Stickstoffspülung und/oder Erhitzung durchgeführt werden kann.

12. Vorrichtung gemäß einem der Ansprüche 2 bis 11, die eine Konditionierungsstation (22) enthält,
- die für die Aufnahme des Mini-Umgebungsbehälters (1) und den Anschluss an den Vorvakuum-Pumpdurchlass (15) ausgelegt ist,
- die eine Vorvakuumpumpe (23) und Steuerungsvorrichtungen (24) umfasst, die dazu dienen, das Gas aus der Reservekammer (13) zu saugen, um in der Reservekammer (13) und dem Innen-Hohlraum (2) des Mini-Umgebungsbehälters (1) ein geeignetes Vakuum zu erzeugen.

13. Vorrichtung gemäß Anspruch 12, in der die Vorvakuumpumpe (23) mit Anschlussvorrichtungen (26) zusammenwirkt, um die Saugfunktion (27) an eine Reservekammer (13) des Mini-Umgebungsbehälters (1) anzuschließen.

14. Vorrichtung gemäß einem der Ansprüche 12 oder 13, in der:
- Die Mikropumpe (12) einem Pumpentyp entspricht, der elektrische Energie nutzt,
- Die Energiereserve (16) des Mini-Umgebungsbehälters (1) Mittel zur Speicherung der elektrischen Energie umfasst,
- Die Konditionierungsstation (22) Mittel umfasst, die als elektrische Energiequelle (25) dienen, und elektrische Anschlussmittel (28), um die Energiereserve (16) des Mini-Umgebungsbehälters (1) aufzuladen.

15. Vorrichtung gemäß einem der Ansprüche 2 bis 14, in der die Reservekammer (13) ein Adsorptionselement (30) umfasst, das die Gasmoleküle adsorbiert und damit dazu beiträgt, in der Reservekammer (13) einen ausreichend niedrigen Druck aufrecht zu erhalten.

16. Vorrichtung gemäß einem der Ansprüche 1 bis 13, **dadurch gekennzeichnet, dass** ein Adsorptionselement (32) in der Atmosphäre des Innen-Hohlraums (2) des Mini-Umgebungsbehälters (1) angeordnet wird, um die Gasmoleküle zu adsorbieren, und damit zur Erhaltung des Vakuums im Innen-Hohlraum (2) und zur Molekülentgiftung beizutragen.

17. Vorrichtung gemäß Anspruch 16, in der das Adsorptionselement (32) demontierbar ist, um seinen Austausch und/oder seine Aufbereitung außerhalb des Mini-Umgebungsbehälters (1) zu ermöglichen.

18. Vorrichtung gemäß Anspruch 17, in der das Adsorptionselement (32) einem Typ entspricht, der bei hohen Temperaturen Desorptionseigenschaften, bzw. bei niedrigen Temperaturen Adsorptionseigenschaften aufweist, und der noch relativ warm in den Mini-Umgebungsbehälter (1) eingelegt werden kann, so dass seine allmähliche Abkühlung die Pumpleistung fördert und zur Aufrechterhaltung des kontrollierten Vakuums im Mini-Umgebungsbehälter (1) beiträgt.

19. Vorrichtung gemäß einem der Ansprüche 1 bis 18, **dadurch gekennzeichnet, dass** sie eine Vorrichtung zur elektrostatischen Befestigung (40) enthält, um das Substrat (3) im Innen-Hohlraum (2) in unveränderter Position zu halten.
